# EUROPEAN PATENT APPLICATION

(11) **EP 3 763 998 A1**
(43) Date of publication of application: **13.01.2021**
(21) Application number: 19185904.0
(22) Date of filing: 12.07.2019
(51) Int. Cl.: F24C 7/08, H03K 17/96

(54) **CONTROL ELEMENT FOR A USER INTERFACE OF A DOMESTIC APPLIANCE**

(71) Applicant: ELECTROLUX APPLIANCES AKTIEBOLAG, 105 45 Stockholm (SE)
(72) Inventor: BASHU, Mathew Alexander, 91541 Rothenburg o.d. Tauber (DE)
(74) Representative: Electrolux Group Patents

(57) **Abstract**

The present invention relates to a control element (10) for a user interface of a domestic appliance, in particular a cooking hob. The control element (10) is attachable on an upper surface or at an outer surface of a glass panel (14). The control element (10) includes a base element (30) attachable on the upper or at the outer surface, respectively, of the glass panel (14). The control element (10) includes a moveable element (26) attached at the base element (30). The control element (10) includes a sensor element (16) connected to and moveable by the moveable element (26). The sensor element (16) is wirelessly connectable or connected to at least one further sensor element (18) arranged beneath the upper or at the inner surface, respectively, of the glass panel (14). Further, the present invention relates to a user interface comprising said control element (10) and at least one printed circuit board (12) arrangeable beneath a lower surface or at an inner surface, respectively, of the glass panel (14).

## Description

The present invention relates to a control element for a user interface of a domestic appliance, in particular a cooking hob. Further, the present invention relates to a user interface of a domestic appliance, in particular a cooking hob. Moreover, the present invention relates to a domestic appliance. In particular, the present invention relates to a cooking hob.

A conventional user interface for a cooking hob comprises control elements arranged on an upper side or at a front side of a glass panel and a printed circuit board arranged beneath or behind said glass panel, respectively. For example, the control element is a rotary knob. The connection between the control elements and the printed circuit board requires holes in the glass panel. However, the drilling of holes in the glass panel is complex and expensive. It would be advantageous, if the holes in the glass panel could be omitted.

It is an object of the present invention to provide a control element for a user interface of a domestic appliance, which may be arranged on or at a glass panel without any holes.

The object is achieved by the control element according to claim 1.

According to the present invention a control element for a user interface of a domestic appliance, in particular of a cooking hob, is provided, wherein:
- the control element is attachable on an upper surface or at an outer surface of a glass panel,
- the control element includes a base element attachable on the upper or at the outer surface, respectively, of the glass panel,
- the control element includes a moveable element attached at the base element,
- the control element includes a sensor element connected to and moveable by the moveable element, and
- the sensor element is wirelessly connectable or connected to at least one further sensor element arranged beneath the upper or at the inner surface, respectively, of the glass panel.

The control element of the present invention allows a wireless connection between said control element and a circuit arranged at the other side of the glass panel. The wireless connection through the glass panel does not require any holes in said glass panel. Neither direct electric connections nor mechanical connections are required between the control element and the circuit. For example, the sensor element of the control element and the further sensor element form a capacitive sensor.

For example, the moveable element is a rotary knob, wherein preferably said rotary knob is made of metal, conductive plastic and/or a combination of metal and plastic. The electric conductivity of the rotary knob allows a conductive path from a touch point of the user to the surface of the glass panel.

Further, the control element may include a metal plate arranged at or inside the moveable element, wherein the sensor element is an appendix of said metal plate.

Alternatively, the sensor element may be directly connected to the moveable element, wherein preferably the sensor element is an appendix of the moveable element.

Preferably, the control element and/or the moveable element are cylindrical.

Further, the control element may include at least one induction coil for supplying electric energy, wherein preferably the control element includes at least one circuitry associated with said induction coil.

Moreover, the control element may include at least one light source element, wherein preferably said light source element is connected to the induction coil and/or the circuitry associated with said induction coil. For example, the light source element is at least one light emitting diode (LED).

Alternatively or additionally, the control element may include at least one vibration element, wherein preferably said light vibration element is connected to the induction coil.

Further, the present invention relates to a user interface comprising at least one control element mentioned above, wherein the user interface comprises at least one printed circuit board arrangeable beneath a lower surface or at an inner surface, respectively, of the glass panel, wherein the printed circuit board includes at least one further sensor element wirelessly connected or connectable to the sensor element of control element.

Preferably, the sensor element and the further sensor element form a capacitive sensor.

Optionally, the printed circuit board includes at least one further induction coil wirelessly connectable or connected to the induction coil of the control element.

At last, the present invention relates to a domestic appliance, in particular a cooking hob, wherein the domestic appliance comprises at least one control element and/or at least one user interface mentioned above.

Novel and inventive features of the present invention are set forth in the appended claims.

The present invention will be described in further detail with reference to the drawing, in which
- FIG 1: illustrates a schematic perspective view of a user interface according to a preferred embodiment of the present invention,
- FIG 2: illustrates a schematic perspective view of the user interface according to a further embodiment of the present invention,
- FIG 3: illustrates a schematic exploded upper perspective view of a control element according to a first embodiment of the present invention,
- FIG 4: illustrates a schematic exploded lower perspective view of the control element according to the first embodiment of the present invention,
- FIG 5: illustrates a schematic top view of the control element according to the first embodiment of the present invention,
- FIG 6: illustrates a schematic sectional perspective view of the control element according to the first embodiment of the present invention,
- FIG 7: illustrates a schematic exploded lower perspective view of the control element according to a second embodiment of the present invention, and
- FIG 8: illustrates a schematic exploded upper perspective view of the control element according to the second embodiment of the present invention.

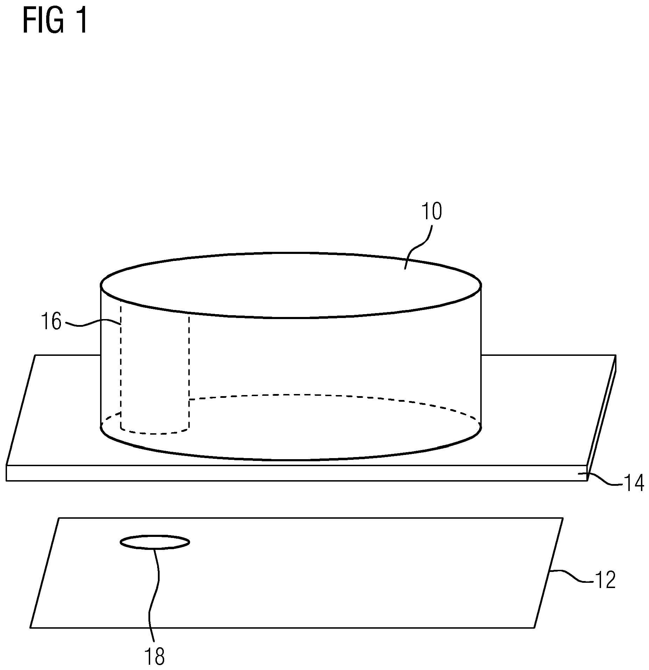

FIG 1 illustrates a schematic perspective view of a user interface according to a preferred embodiment of the present invention. The user interface is provided for a domestic appliance, in particular for a cooking hob.

The user interface comprises at least one control element 10 and a printed circuit board 12. The control element 10 is arranged above a glass panel 14, while the printed circuit board 12 is arranged beneath said glass panel 14. In this example, the glass panel 14 is arranged horizontally and forms a part of a cooking hob.

The control element 10 is cylindrical and attached on the upper surface of the glass panel 14. The control element 10 includes a first sensor element 16 arranged inside said control element 10. The first sensor element 16 is arranged in an outer portion within the control element 10.

The printed circuit board 12 is arranged beneath the glass panel 14. In this example, the printed circuit board 12 is arranged horizontally and extends substantially parallel to the glass panel 14. The printed circuit board 12 includes a second sensor element 18.

The control element 10 is rotatable around its axis of rotational symmetry. The user interface is manipulated by touching the control element 10. Further, by rotating the control element 10 the position of the first sensor element 16 changes. The distance between the first sensor element 16 and the second sensor element 18 varies by the rotation of the control element 10. In a limit case, the first sensor element 16 is arranged directly above the second sensor element 18.

For example, the first sensor element 16 and the second sensor element 18 form a capacitive sensor.

A control signal is generated in the second sensor element 18. The signal strength of said control signal depends on the distance between the first sensor element 16 and the second sensor element 18. When the first sensor element 16 is arranged directly in-line with the second sensor element 18, then a capacitance is generated, wherein the signal strength of said capacitance is used for detecting the position of the control element 10. Preferably, a plurality of second sensor elements 18 is arranged in a circular path extending along the circumference of the path of the first sensor element 16.

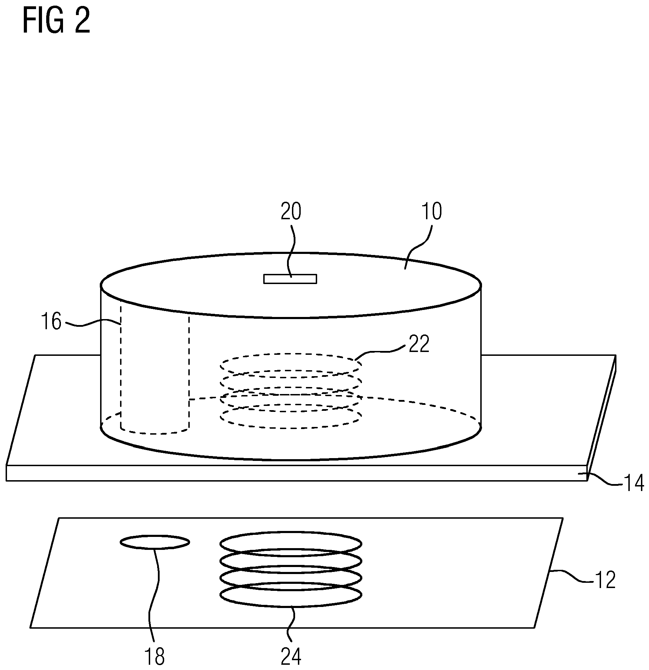

FIG 2 illustrates a schematic perspective view of the user interface according to a further embodiment of the present invention.

In the further embodiment the control element 10 includes the first sensor element 16 and additionally a light source element 20 and a first induction coil 22 with an associated circuitry, while the printed circuit board 12 includes the second sensor element 18 and additionally a second induction coil 24 with an associated circuitry.

The first induction coil 22 and the second induction coil 24 provide an inductive coupling between the printed circuit board 12 and the control element 10. Said inductive coupling allows a wireless electric energy transfer from the printed circuit board 12 to the control element 10. In this example, the light source element 20 is supplied via said inductive coupling.

Preferably, the light source element 20 consists of one or more light emitting diodes. The control element 10 is illuminated by the light source element 20.

Optionally, the control element 10 includes a vibration element 20 instead of or in addition to the light source element 20. For example, the vibration element 20 is an aid for people with disabilities.

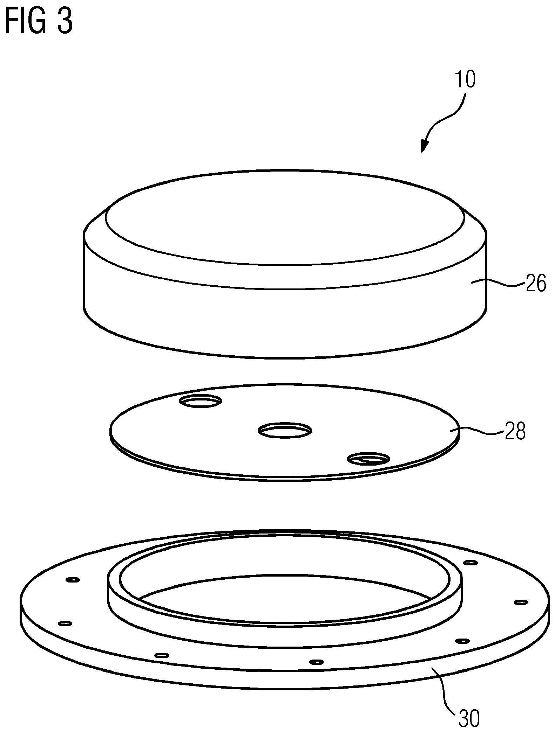

FIG 3 illustrates a schematic exploded upper perspective view of the control element 10 according to a first embodiment of the present invention.

The control element 10 includes a rotary knob 26, a metal plate 28 and a base plate 30. The base plate 30 is attachable or attached on the upper surface of the glass panel 14. For example, the base plate 30 is glued on the upper surface of the glass panel 14. The rotary knob 26 is rotatable on the base plate 30. Preferably, the rotary knob 26 is made of metal, conductive plastic and/or a combination of metal and plastic.

The metal plate 28 is attached inside the rotary knob 26. Thus, the metal plate 28 is rotated synchronously with the rotary knob 26.

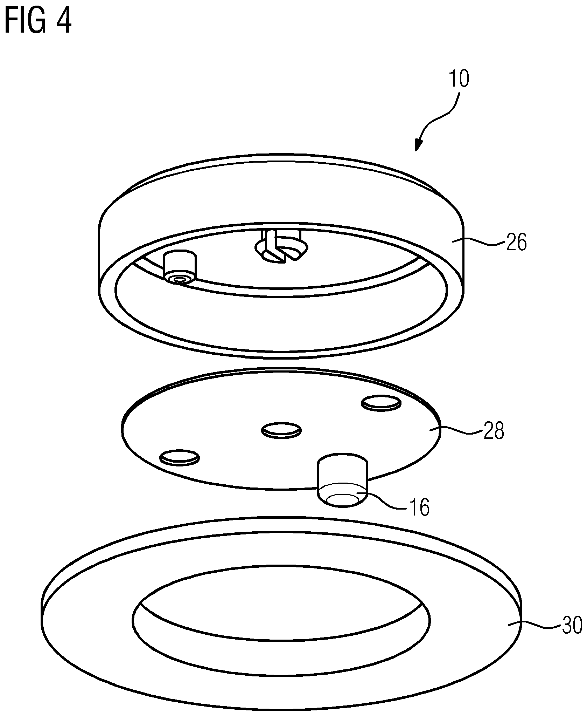

FIG 4 illustrates a schematic exploded lower perspective view of the control element 10 according to the first embodiment of the present invention.

The control element 10 includes the rotary knob 26, the metal plate 28 and the base plate 30. The base plate 30 is attachable or attached on the upper surface of the glass panel 14. The rotary knob 26 with the metal plate 28 is rotatable on the base plate 30.

The first sensor element 16 is attached at the metal plate 28. For example, the metal plate 28 and the first sensor element 16 form a single-piece part.

The rotation of the rotary knob 26 with the metal plate 28 causes a movement of the first sensor element 16. Thus, the rotation of the rotary knob 26 changes the distance between the first sensor element 16 and the second sensor element 18.

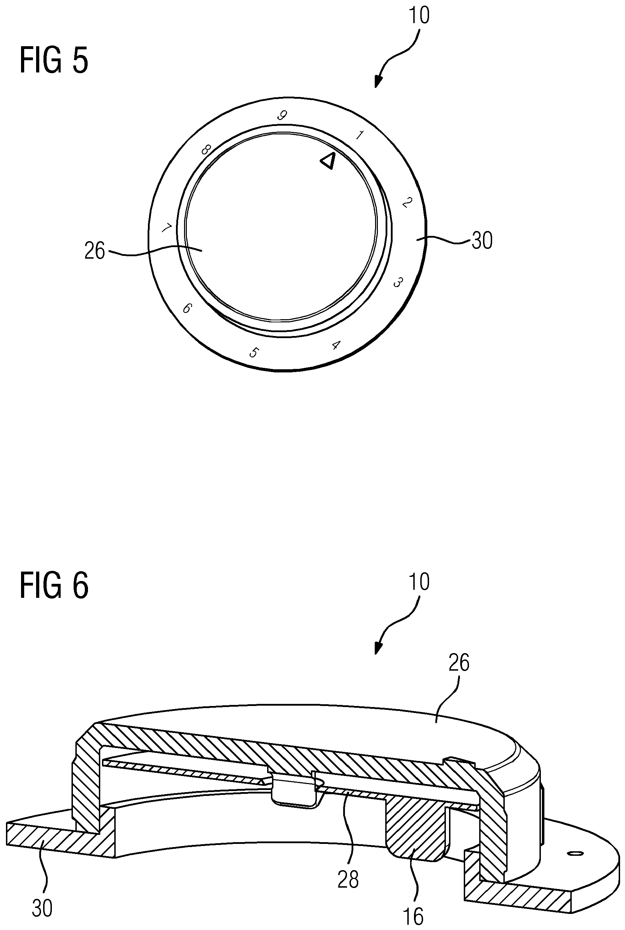

FIG 5 illustrates a schematic top view of the control element 10 according to the first embodiment of the present invention.

The control element 10 includes the rotary knob 26 and the base plate 30. The base plate 30 is attached on the upper surface of the glass panel 14. The rotary knob 26 with the metal plate 28 is rotatable on the base plate 30.

FIG 6 illustrates a schematic sectional perspective view of the control element 10 according to the first embodiment of the present invention.

The control element 10 includes the rotary knob 26, the metal plate 28 and the base plate 30. The base plate 30 is attached on the upper surface of the glass panel 14. The first sensor element 16 is attached at the metal plate 28. For example, the metal plate 28 and the first sensor element 16 form a single-piece part.

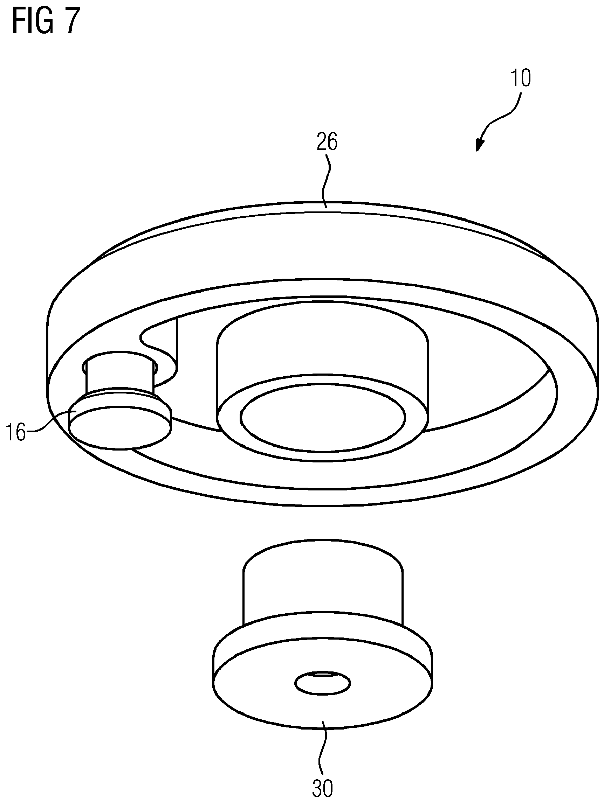

FIG 7 illustrates a schematic exploded lower perspective view of the control element 10 according to a second embodiment of the present invention.

The control element 10 includes the rotary knob 26 and the base plate 30. The base plate 30 is attachable or attached on the upper surface of the glass panel 14. For example, the base plate 30 is glued on the upper surface of the glass panel 14. The rotary knob 26 is rotatable on the base plate 30. Preferably, the rotary knob 26 is made of metal, conductive plastic and/or a combination of metal and plastic.

The first sensor element 16 is directly attached at the rotary knob 26. For example, the rotary knob 26 and the first sensor element 16 form a single-piece part. The control element 10 of the second embodiment does not require the metal plate 28.

The rotation of the rotary knob 26 causes the movement of the first sensor element 16. Thus, the rotation of the rotary knob 26 changes the distance between the first sensor element 16 and the second sensor element 18.

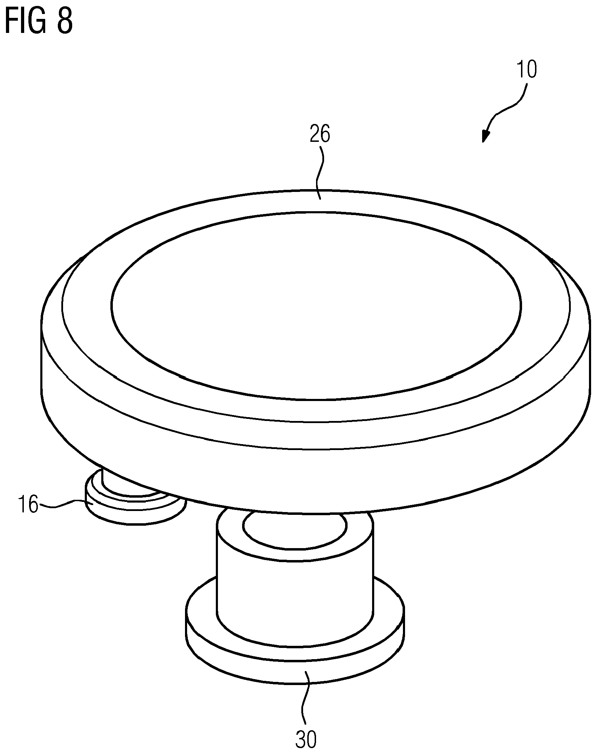

FIG 8 illustrates a schematic exploded upper perspective view of the control element 10 according to the second embodiment of the present invention.

The control element 10 includes the rotary knob 26 and the base plate 30. The base plate 30 is attachable or attached on the upper surface of the glass panel 14. The first sensor element 16 is directly attached at the rotary knob 26. For example, the rotary knob 26 and the first sensor element 16 form a single-piece part. The rotary knob 26 with the first sensor element 16 is rotatable on the base plate 30.

The control element 10 according to the second embodiment does not include the metal plate 28 and may be realised by low complexity.

The user interface of the present invention provides a wireless connection between the control element 10 and the printed circuit board 12 arranged at different sides of the glass panel 14. The wireless connection through the glass panel 14 does not require any holes in said glass panel 14.

Although illustrative embodiments of the present invention have been described herein with reference to the accompanying drawings, it is to be understood that the present invention is not limited to those precise embodiment, and that various other changes and modifications may be affected therein by one skilled in the art without departing from the scope or spirit of the invention. All such changes and modifications are intended to be included within the scope of the invention as defined by the appended claims.

### List of reference numerals

- 10: control element
- 12: printed circuit board
- 14: glass panel
- 16: first sensor element
- 18: second sensor element
- 20: light source element, vibration element
- 22: first induction coil
- 24: second induction coil
- 26: rotary knob
- 28: metal plate
- 30: base plate

## Claims

1. A control element (10) for a user interface of a domestic appliance, in particular of a cooking hob, wherein:
- the control element (10) is attachable on an upper surface or at an outer surface of a glass panel (14),
- the control element (10) includes a base element (30) attachable on the upper or at the outer surface, respectively, of the glass panel (14),
- the control element (10) includes a moveable element (26) attached at the base element (30),
- the control element (10) includes a sensor element (16) connected to and moveable by the moveable element (26), and
- the sensor element (16) is wirelessly connectable or connected to at least one further sensor element (18) arranged beneath the upper or at the inner surface, respectively, of the glass panel (14).

2. The control element according to claim 1,
**characterised in that**
the moveable element (26) is a rotary knob (26), wherein preferably said rotary knob (26) is made of metal, conductive plastic and/or a combination of metal and plastic.

3. The control element according to claim 1 or 2,
**characterised in that**
the control element (10) includes a metal plate (28) arranged at or inside the moveable element (26), wherein the sensor element (16) is an appendix of said metal plate (28).

4. The control element according to claim 1 or 2,
**characterised in that**
the sensor element (16) is directly connected to the moveable element (26), wherein preferably the sensor element (16) is an appendix of the moveable element (26).

5. The control element according to any one of the preceding claims,
**characterised in that**
the control element (10) and/or the moveable element (26) are cylindrical.

6. The control element according to any one of the preceding claims,
**characterised in that**
the control element (10) includes at least one induction coil (22) for supplying electric energy, wherein preferably the control element (10) includes at least one circuitry associated with said induction coil (22).

7. The control element according to any one of the preceding claims,
**characterised in that**
the control element (10) includes at least one light source element (20), wherein preferably said light source element (20) is connected to the induction coil (22) and/or the circuitry associated with said induction coil (22).

8. The control element according to any one of the preceding claims,
**characterised in that**
the control element (10) includes at least one vibration element (20), wherein preferably said light vibration element (20) is connected to the induction coil (22).

9. A user interface comprising at least one control element (10) according to any one of the preceding claims,
**characterised in that**
the user interface comprises at least one printed circuit board (12) arrangeable beneath a lower surface or at an inner surface, respectively, of the glass panel (14), wherein the printed circuit board (12) includes at least one further sensor element (18) wirelessly connected or connectable to the sensor element (16) of control element (10).

10. The user interface according to claim 9,
**characterised in that**
the sensor element (16) and the further sensor element (18) form a capacitive sensor.

11. The user interface according to claim 9 or 10,
**characterised in that**
the printed circuit board (12) includes at least one further induction coil (24) wirelessly connectable or connected to the induction coil (22) of the control element (10).

12. A domestic appliance, in particular a cooking hob,
**characterised in that**
the domestic appliance comprises at least one control element (10) according to any one of the claims 1 to 8 and/or at least one user interface according to any one of the claims 9 to 11.
